(19) Europäisches Patentamt
European Patent Office
Office européen des brevets

(11) **EP 2 669 690 A1**

(12) **EUROPEAN PATENT APPLICATION**
published in accordance with Art. 153(4) EPC

(43) Date of publication:
04.12.2013 Bulletin 2013/49

(51) Int Cl.:
*G01R 31/00* (2006.01)  *G01R 19/00* (2006.01)
*G01R 1/067* (2006.01)  *G08C 17/02* (2006.01)

(21) Application number: 11856100.0

(22) Date of filing: 17.11.2011

(86) International application number:
**PCT/CN2011/001919**

(87) International publication number:
**WO 2012/097492 (26.07.2012 Gazette 2012/30)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: 20.01.2011 CN 201110022620

(71) Applicants:
• **Liaoning Electric Power Company Ltd**
**Liaoning 110006 (CN)**
• **Liaoning Electric Power Company Limited Power Scientific Research Institution**
**Shenyang, Liaoning 110006 (CN)**
• **Northeast Power Scientific Research Institution Ltd.**
**Liaoning 110006 (CN)**
• **Liaoning Dongke Power Ltd**
**Liaoning 110179 (CN)**
• **State Grid Corporation of China**
**Beijing 100031 (CN)**

(72) Inventors:
• **GAO, Qiang**
**Liaoning 110006 (CN)**
• **ZHONG, Dantian**
**Liaoning 110006 (CN)**
• **GENG, Baohong**
**Liaoning 110006 (CN)**
• **ZHANG, Junyang**
**Liaoning 110006 (CN)**
• **WANG, Maojun**
**Liaoning 110006 (CN)**
• **ZHU, Yu**
**Liaoning 110006 (CN)**

(74) Representative: **Dossmann, Gérard**
**Casalonga & Partners**
**Bayerstrasse 71-73**
**80335 München (DE)**

(54) **WIRELESS SYSTEM FOR MEASURING VOLTAGE DISTRIBUTION OF ARRESTER**

(57) A wireless system for measuring voltage distribution of arrester acquires the voltage of each node of the arrester synchronously by a wireless transmission method. The voltage of a transformer can be measured by a host (2), and the acquisition of the voltage is only at an interval of 0.6 ms with the acquisition of the voltage of the node of the arrester by each voltage measuring probe (1), so measuring accuracy cannot be influenced. A discrete Fourier transform method is applied in signal processing to analyze and calculate the acquired voltage signal. An interference harmonic wave is filtered and base wave voltage is accurately calculated to ensure the measuring accuracy.

FIG.1

**Description**

Technical Field

This patent is used in the field of measurement of the voltage distribution along metal-oxide surge arresters, especially a method of measurement of the voltage distribution along metal-oxide surge arresters based on wireless communication technology.

Background Art

The voltage distribution along a metal-oxide surge arrester is governed by the capacitances and resistances of the non-linear resistors, the stray capacitances from the non-linear resistor column and metal flanges to earthed and live parts, and the boundary conditions (applied voltage, proximity and voltage applied to other objects in the vicinity). Stray capacitances result in uneven voltage distribution along the resistor column, with the maximum voltage stress typically appearing in the upper part of the arrester. The uneven voltage distribution along a metal-oxide surge arrester would make the arrester be accelerated aging and even result in thermal breakdown.

The voltage distribution may be determined by means of commonly available computer programs, such as Finite Element Method (FEM), Boundary Element Method (BEM), Simulation Charge Method (SCM) etc., for calculation of electric fields and circuits. The results of such calculations are, however, dependent on the representations of the surge arrester and prevailing boundary conditions.

Modeling of a surge arrester, since the stray capacitances are important to the voltage distribution along the non-linear resistor column, the influence of the various simplifications in the surge arrester model must be considered with respect to these capacitances.

Modeling the boundary conditions, for surge arresters in typical three-phase out door installations, for example, in substations, the boundary conditions are determined by the distances to earthed structures and adjacent phases. In general, this is a truly three-dimensional electric field problem, where both the magnitude and phase angle of the applied voltages need to be considered.

Calculation procedure, the calculation procedure may be performed in two different ways. One is capacitive representation of the non-linear resistor column, in this case, the non-linear resistor is represented exclusively by its capacitance (permittivity), neglecting the influence of the resistive characteristic. The other way is capacitive and resistive representation of the non-linear resistor column. Here, the non-linear resistor column is represented by its capacitance in parallel to its non-linear resistive characteristic. Therefore, from the above mentioned calculation procedure, it is very difficult to model the arrester and the boundary conditions, so the result based on the calculation method is not accurate and reliable, in fact, the manufacturer of the metal-oxide surge arrester have to do some direct measurement to get the voltage distribution result of the metal-oxide surge arrester. Especially, each new designed product will be required to pass the type test of the voltage distribution measurement.

The photoelectricity measurement method is a direct way to measure the voltage distribution along metal-oxide surge arrester. The measurement system consists of an electrical-to-optical current transducer, optical-fiber cable, photoelectric converter, signal amplifier, and signal processing and recording system. The photoelectricity measurement method use current transducers which placed inside the surge arrester among the metal-oxide discs with the same size of the metal-oxide disc to measure the leakage current through the arrester while the test voltage applied to the surge arrester. The fiber measuring system of the voltage distribution along the metal-oxide surge arrester is using the fiber communication technology as an insulation method to measuring the high voltage testing results. The photoelectricity measurement method has some disadvantages, such as, each current transducer has to have an interface with the fiber, the fiber is easy to be broken or bent, the house of the surge arrester has to be drilled holes to let the bundle of the fiber to reach the oscilloscope to finish the measurement, current transducers can't perform the measurement at the same time, the efficiency of the measurement is relatively low as the fiber is broken or bent by accident.

Brief Description of the Invention

The voltage distribution along a metal-oxide surge arrester is governed by the capacitances and resistances of the non-linear resistors, the stray capacitances from the non-linear resistor column and metal flanges to earthed and live parts, and the boundary conditions (applied voltage, proximity and voltage applied to other objects in the vicinity). Stray capacitances result in uneven voltage distribution along the resistor column, with the maximum voltage stress typically appearing in the upper part of the arrester. The uneven voltage distribution along a metal-oxide surge arrester would make the arrester be accelerated aging and even result in thermal breakdown.

The fundamental principle of the voltage distribution along the metal-oxide surge arrester is to measure the leakage current through every metal-oxide disc under the applied power frequency testing voltage, the voltage distribution can be analyzed from the leakage currents though every metal-oxide disc in the column of the surge arrester. Ordinarily, the voltage-current characteristic of the metal-oxide arrester can be divided into a small current region, medium current region and high current region. When the power frequency testing voltage is applied to the surge arrester, it works in a small current region and the capacitance of each metal-oxide disc is given by manufacturer. The leakage current though the different metal-oxide disc is a bit different due to the influence of stray capacitances between the metal-oxide disc blocks and surrounding objects, and between the metal-oxide disc blocks and the high voltage conductors. The type test of the voltage distribution is to set the voltage distribution coefficient in a controlled in a range within $\pm 15\%$. The coefficient can be lowered though adjust the size of the grading ring of the surge arrester, parallel capacitors, size of the surge arrester, etc...

Therefore, the present invention has been in view of the above methods, and it is an object of the present invention to provide a wireless measuring system of the voltage distribution along the metal-oxide surge arrester. The present invention use current transducers which placed inside the surge arrester among the metal-oxide discs with the same size of the metal-oxide disc to measure the leakage current through the arrester while the test voltage applied to the surge arrester. The wireless measuring system of the voltage distribution along the metal-oxide surge arrester is using the wireless communication technology as an insulation method to measuring the high voltage testing results. The voltage transducer can communicate with all the current transducers placed among the discs of the surge arrester. The voltage distribution results can be calculated through software installed on a laptop computer.

The present invention has the following advantages: easy to install the current transducer along the metal-oxide disc column, and no wires and fiber needed; with the help of the Discrete Fourier Transform algorithm, the measuring results are more accurate and stable; the synchronous measurement between all the current transducers and voltage transducer, make the measurement more accurate and reliable; with the wireless communication the test efficiency improved a lot.

BRIEF DESCRIPTION OF THE DRAWINGS

The accompanying drawings, which are incorporated in and constitute a part of this specification, illustrate embodiments and together with the description, serve to explain the principles of the methods and systems:

FIG. 1 is a block diagram of the wireless measuring system of the voltage distribution;

FIG. 2 is a structure description of the current transducer;

FIG. 3 is an exemplary illustration of the inner structure of the current transducer with the upper cover open;

FIG.4 is an exemplary illustration of the inner parts of the current transducer without the upper cover;

FIG.5 is an illustration of the installation of the current transducer in the middle of the metal oxide surge arrester discs;

FIG.6 is a structure description of the voltage transducer;

FIG.7 is exemplary illustration of the inner structure of the voltage transducer;

FIG.8 is the overall structure of the voltage transducer;

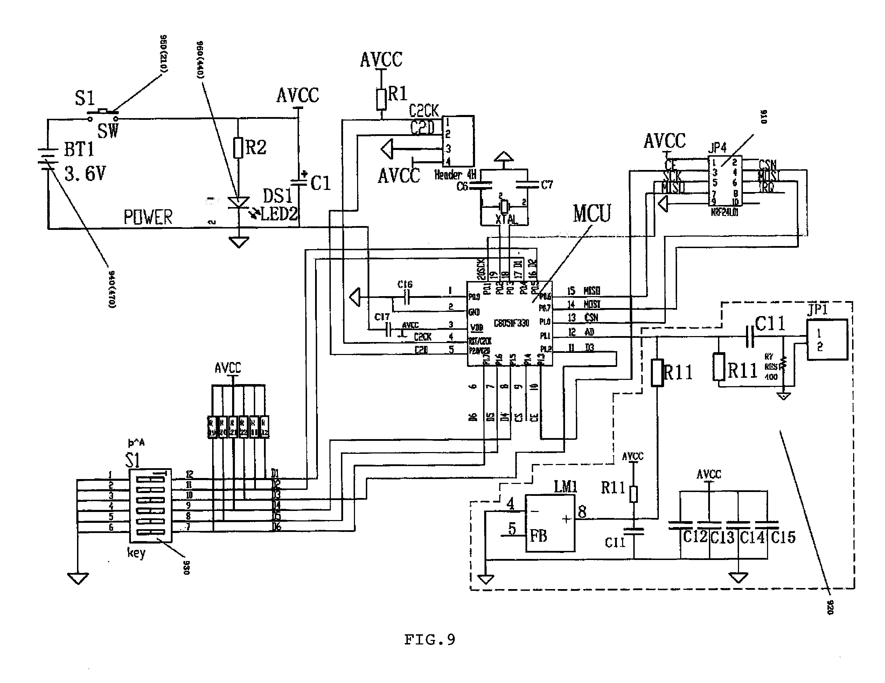

FIG.9 is the schematic of the voltage transducer;

FIG.10 is the schematic of the current transducer;

FIG.11 is the screenshot of the measuring software to show the interface of the measuring parameter setting;

FIG.12 is the screenshot of the measuring software to show the interface of the measuring results.

DETAILED DESCRIPTION OF THE PREFERRED EMBODIMENT

Embodiment of the present invention will now be described in detail with reference to the drawings.

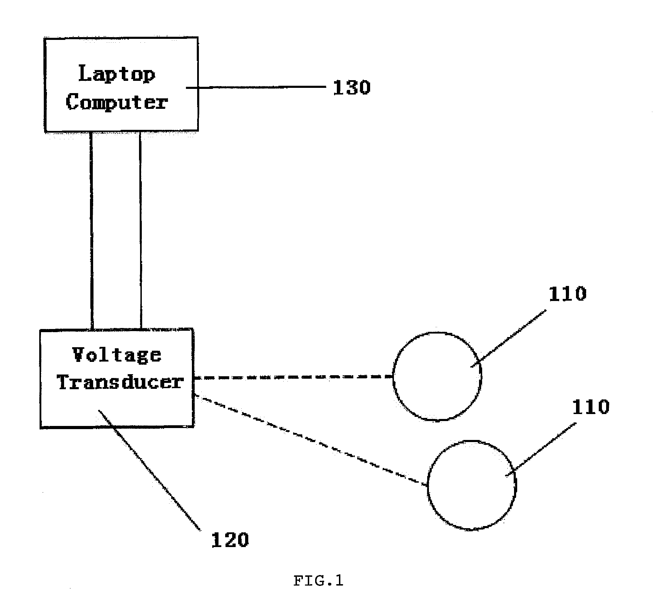

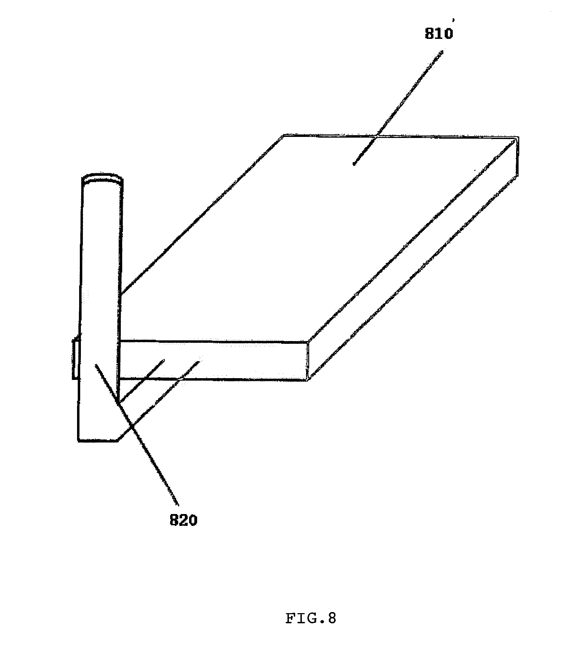

FIG.1 shows a group of leakage current measuring current transducers (110) with wireless communication module and antenna; One applied testing voltage transducer (120) with wireless communication module and antenna and a RS485 communication interface with the laptop computer(130); The current transducer (110) is formed of insulation plastic material with two thick metal plate covered on each side of the box, the measuring circuit lies in the inside of the box with an internal antenna; The voltage transducer (120) is formed of aluminium box (810) with measuring circuits inside the box and with a wireless antenna(820), the embodiment as shown in FIG.8.

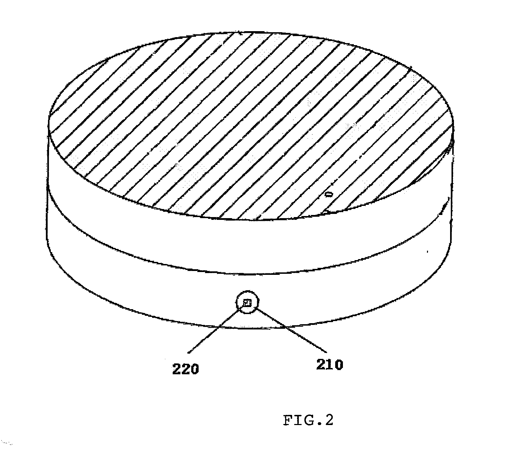

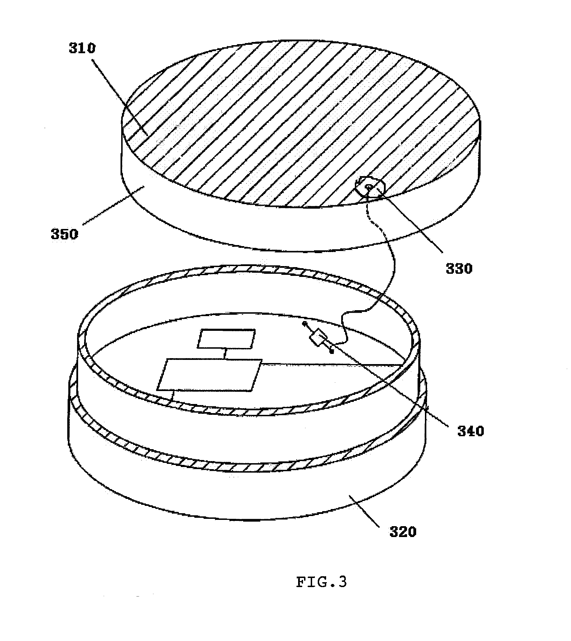

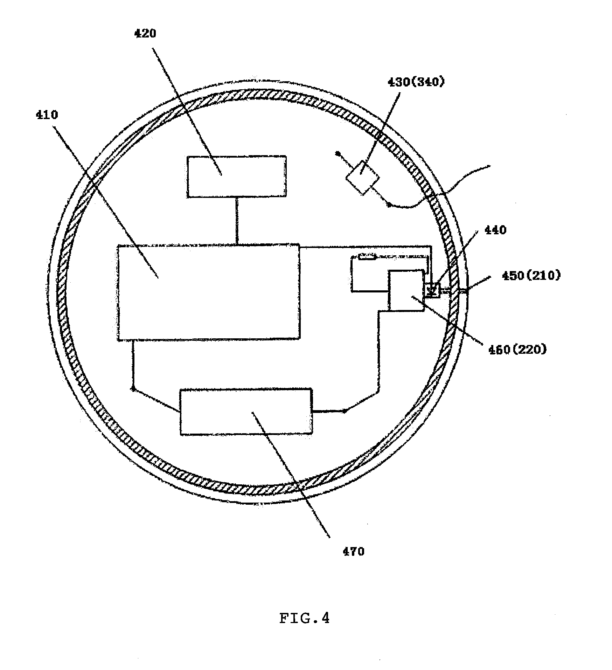

FIG.2, FIG.3, FIG.4 shows the embodiment drawings of the current transducer (110). The current transducer (110) is formed of insulation plastic material with two thick metal plate covered on each side of the box, the cover of the upper part of the box (350) and the bottom cover of the box (320) are made of printed circuit board with only one side placed with solid polygon plane with a soldering pad (330), the sampling resister (340) and measuring circuit are place inside the box with two wires sold with the upper and lower cover pad (330). The solid polygon copper plane is a bit smaller than the circular printed circuit board, the upper cover (350) and bottom cover (320) are glued with the upper and lower part of the box respectively, the embodiments shown in FIG.3. The lower part of the current transducer (110) has a hole (210) on its side, a switch (220) is in the hole, when press the switch the current transducer (110) will be powered on and a diode LED (440) will be lighted to indicate whether the current transducer (110) is power on or not, the embodiments shown in FIG.2 and FIG.4.

The current transducer (110) comprising: a microchip computer controller (short for MCU) (410) and a wireless communication module with internal antenna, sampling resister (430) and conditioning circuit (920), power switch (450), power diode LED indicator (440), battery (470), dip switch (420); The wireless communication module with antenna linked with the dip switch (420), battery (470) and power switch (450); The MCU (410) and wireless communication module are supply by the battery (470), to make the current transducer (110) to fulfill the type test of the voltage distribution the power consumption of the circuit should be considered, especially low consumption chip should be adopted; The dip switch (420) is to set the identification address of the current transducer (110), the range of the identification address can be set to 1 to 64;

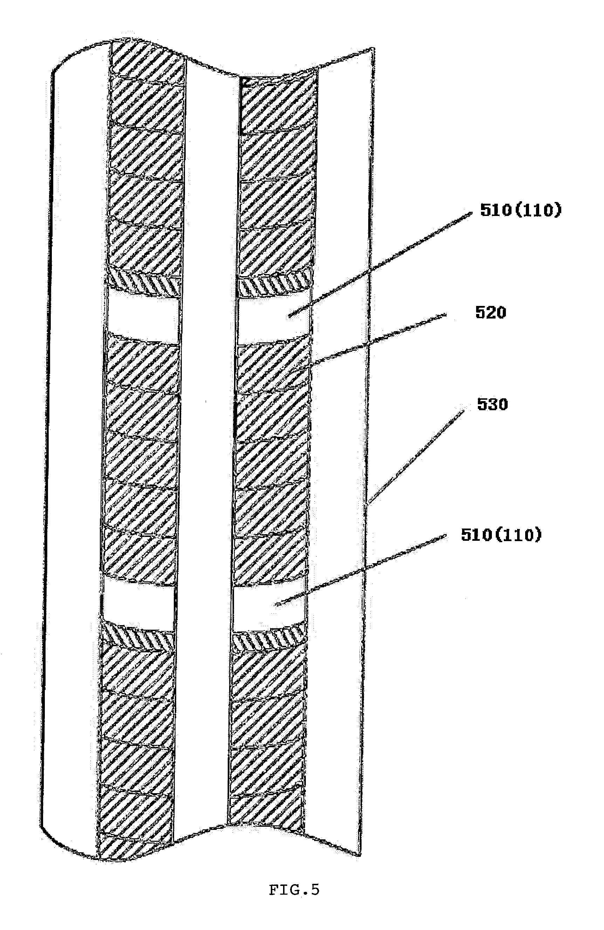

FIG.5 shows the embodiments of the measuring current transducers (110) are placed inside the metal-oxide surge arrester (530) between the discs (520) of the metal-oxide surge arrester;

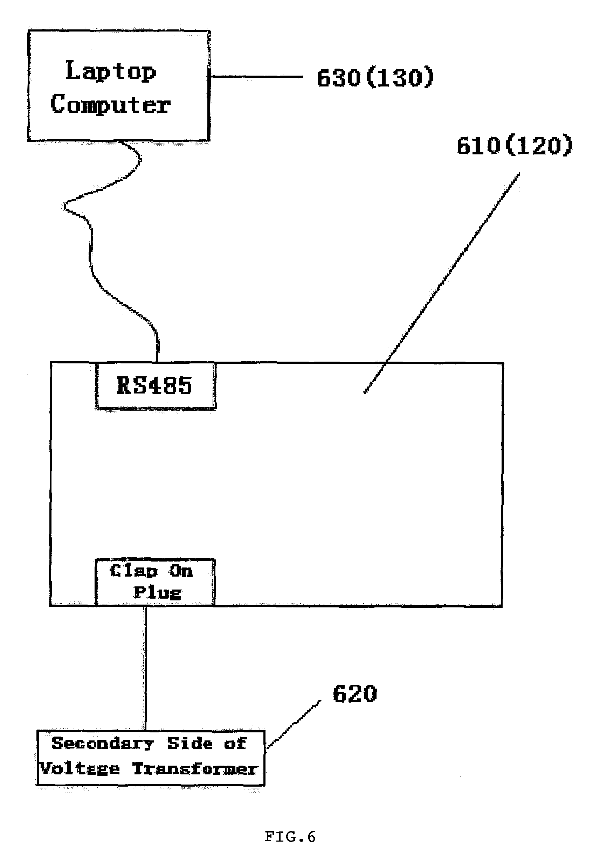

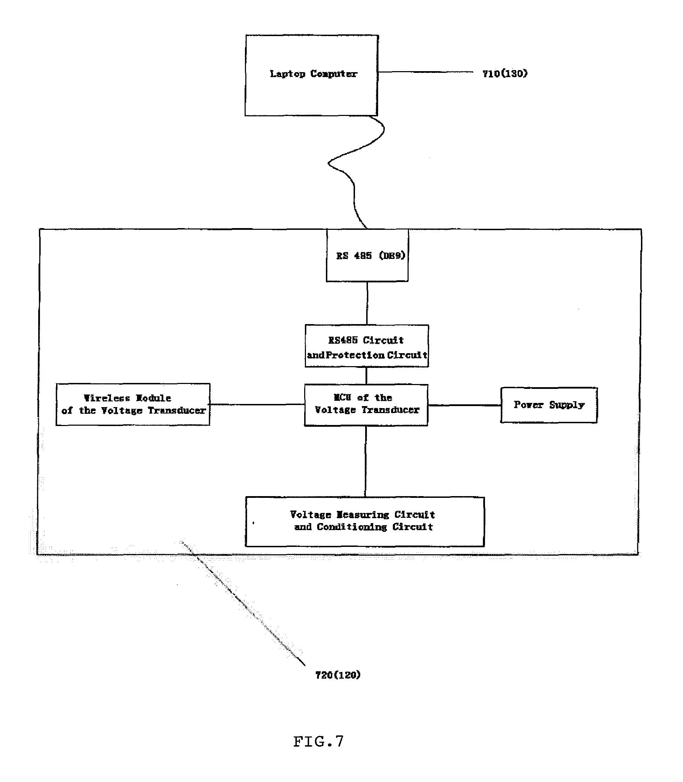

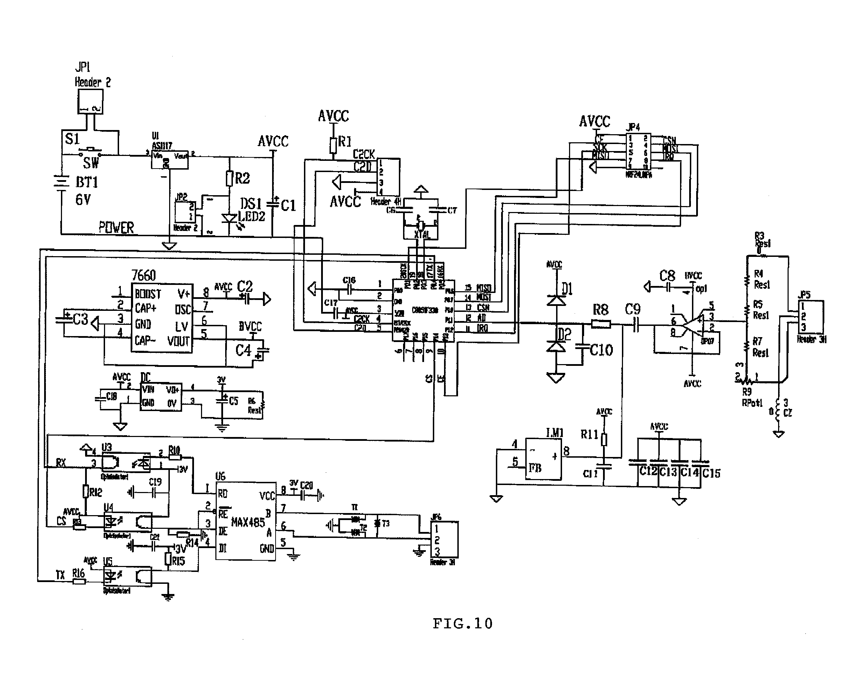

FIG.6 shows the applied voltage to the metal-oxide surge arrester under test is obtained through the voltage transducer (120). The voltage transducer (120) is composed of an aluminium box (810) with a wireless antenna (820) mounted on the side of the aluminium box (810),shown in FIG.8, the voltage transducer (120) can communicate with all current transducers placed inside the surge arrester through the wireless antenna (820) and the wireless antenna inside in the current transducer (110), after that the measuring result of the current transducer (110) and the voltage transducer (120) will be sent to the laptop computer (130) through a RS485 converter. The aluminium box (810) has a RS 485 interface (730) with DB9 connector and a plug to connect the secondary side of the voltage transformer (620) with a two wire shielded cable. The circuit inside the voltage transducer is composed of RS 485 interface (730), RS485 circuit with transient overvoltage protection circuit (740), microchip computer controller (750), battery serves as power supply (760), wireless communication module (770) and voltage measuring circuit and conditioning circuit (780), shown in FIG.7. The schematic of the voltage transducer (120) is shown in the FIG.10.

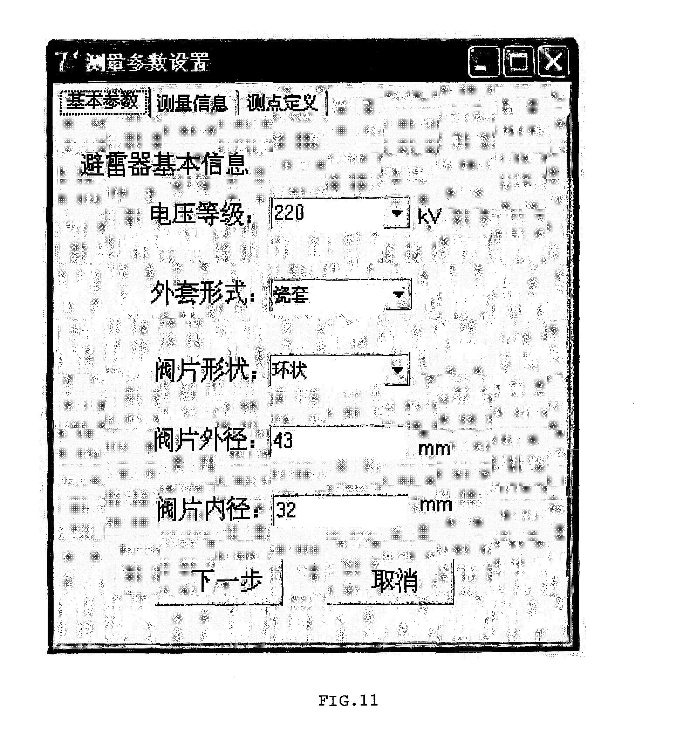

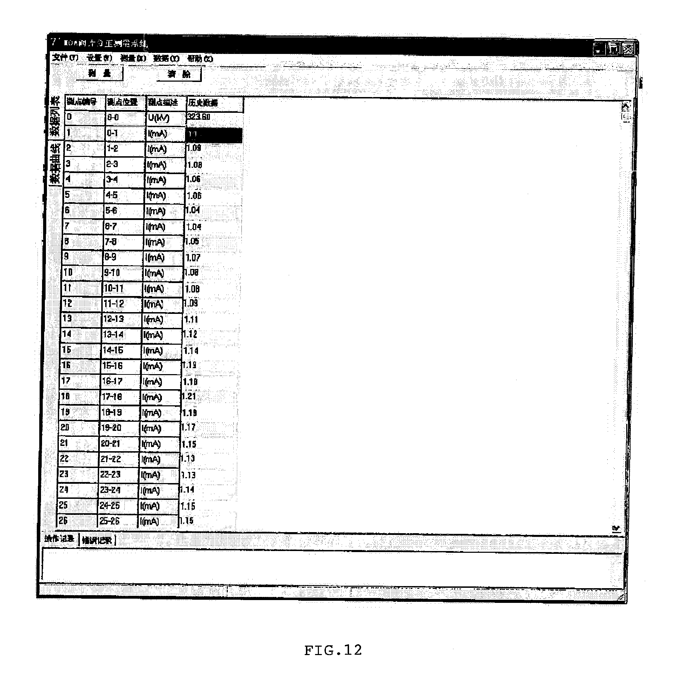

The software installed on the laptop computer (130) was programmed by the Delphi language. The interface of the software is shown in the FIG.11 and FIG.12. FIG.11 shows the parameter setting of the measuring system, which comprising the following parameters: selection of the test voltage level applied to the surge arrester, selection the type of surge arrester porcelain-housed arrester or polymer-housed arrester, selection the shape of the metal-oxide disc circular type or ring type, set the diameter of the metal-oxide disc, etc... FIG.12 shows the measuring results of the system comprising: the identification number of the current transducer (110), the exact place of the current transducers (110) along the metal-oxide disc column, the measuring results of the current transducers (110) and voltage transducers (120). As the FIG.12 shows, there is a button to start the measurements. When the start button is clicked, the software will send the command to the voltage transducer (120) through RS485 cable, the voltage transducer will start to measure the voltage applied to the surge arrester under test and also the starting measurement command will be sent to the current transducers (110) from the voltage transducer (120) antenna to the current transducer (110) antenna. After measurement, a command will be sent to get all measurement result from the transducers to the software as shown in the FIG.12.

Leakage current of the surge arrester is detected by a current transducer with the same size of the disc. At the same time the applied test voltage signal from the secondary of the potential transformer (PT) is also detected. With the help of the Discrete Fourier Transform (DFT) algorithm, the fundamental frequency signals of the current and voltage were obtained. Afterwards, the voltage distribution along the metal-oxide surge arrester could be derived by the fundamental amplitude of the applied test voltage and leakage current though equation (1).

$$U = I/(2\pi f\, UC) \qquad (1)$$

Suppose $u(t)$ and $i(t)$ are simultaneously measured continuous voltage and current signals from single-phase power equipment, then their Fourier series can be written a general form as follow.

$$f(t) = a_0 + \sum_{n=1}^{\infty}(a_n \cos(n\omega_0 t) + b_n \sin(n\omega_0 t)) \quad (2)$$

Where $a_0$ is the dc component of the $f(t)$ signal, the harmonics of this $f(t)$ signal have frequencies $n\omega_0$, where $\omega_0$ is the fundamental frequency and n=1, 2, 3,.... Through Fourier analysis, the constants $\omega_0$, $a_0$, $a_n$, $b_n$ can be determined by the following equations.

$$\omega_0 = 2\pi/T \qquad\qquad (3)$$

$$a_0 = \frac{1}{T}\int_0^T f(t)dt \qquad\qquad (4)$$

$$a_n = \frac{2}{T}\int_0^T f(t)\cos n\omega_0 t dt \qquad\qquad (5)$$

$$b_n = \frac{2}{T}\int_0^T f(t)\sin n\omega_0 t dt \qquad\qquad (6)$$

The amplitude of the $n$th harmonics at a frequency $n\omega_0$ will be $A_n = \sqrt{a_n^2 + b_n^2}$ . The fundamental amplitude of the voltage and current signals $U, I$ can be calculated through the above equations. With the help of the Discrete Fourier Transform (DFT) algorithm, the result of the measurement is immune to the disturbance of the higher harmonics in the applied testing voltage and leakage current.

The invention, wireless measuring system of the voltage distribution along the metal-oxide surge arrester, was used to measuring the type test of a porcelain-housed arrester and a polymer housed arrester manufactured by a company. The test results of the two products are shown in the TABLE.1 and TABLE.2 respectively.

TABLE.1 is the test results of the porcelain-housed arrester

| No.Transducer | place of Transducer | Transducer (Unit) | Measurement Results |
|---|---|---|---|
| 0 | 0-0 | V(KV) | 323.5 |
| 1 | 0-1 | I(mA) | 1.08 |
| 2 | 1-2 | I(mA) | 1.05 |
| 3 | 2-3 | I(mA) | 1.03 |
| 4 | 3-4 | I(mA) | 1.10 |
| 5 | 4-5 | I(mA) | 1.00 |
| 6 | 5-6 | I(mA) | 1.01 |
| 7 | 6-7 | I(mA) | 1.01 |
| 8 | 7-8 | I(mA) | 1.03 |
| 9 | 8-9 | I(mA) | 1.03 |
| 10 | 9-10 | I(mA) | 1.04 |
| 11 | 10-11 | I(mA) | 1.05 |
| 12 | 11-12 | I(mA) | 1.05 |
| 13 | 12-13 | I(mA) | 1.07 |

(continued)

| No.Transducer | place of Transducer | Transducer (Unit) | Measurement Results |
|---|---|---|---|
| 14 | 13-14 | I(mA) | 1.08 |
| 15 | 14-15 | I(mA) | 1.11 |
| 16 | 15-16 | I(mA) | 1.12 |
| 17 | 16-17 | I(mA) | 1.14 |
| 18 | 17-18 | I(mA) | 1.08 |
| 19 | 18-19 | I(mA) | 1.05 |
| 20 | 19-20 | I(mA) | 1.05 |
| 21 | 20-21 | I(mA) | 1.02 |
| 22 | 21-22 | I(mA) | 1.00 |
| 23 | 22-23 | I(mA) | 0.98 |
| 24 | 23-24 | I(mA) | 0.95 |
| 25 | 24-25 | I(mA) | 0.95 |
| 26 | 25-26 | I(mA) | 0.95 |

TABLE.2 is the test results of the polymer housed arrester

| No.Transducer | place of Transducer | Transducer (Unit) | Measurement results |
|---|---|---|---|
| 0 | 0-0 | V(KV) | 323.6 |
| 1 | 0-1 | I(mA) | 1.13 |
| 2 | 1-2 | I(MA) | 1.09 |
| 3 | 2-3 | I(mA) | 1.08 |
| 4 | 3-4 | I(mA) | 1.06 |
| 5 | 4-5 | I(mA) | 1.06 |
| 6 | 5-6 | I(mA) | 1.04 |
| 7 | 6-7 | I(mA) | 1.04 |
| 8 | 7-8 | I(mA) | 1.05 |
| 9 | 8-9 | I(mA) | 1.07 |
| 16 | 9-10 | I(mA) | 1.08 |
| 11 | 10-11 | I(mA) | 1.08 |
| 12 | 11-12 | I(mA) | 1.09 |
| 13 | 12-13 | I(mA) | 1.11 |
| 14 | 13-14 | I(mA) | 1.12 |
| 15 | 14-15 | I(mA) | 1.14 |
| 16 | 15-16 | I(mA) | 1.19 |
| 17 | 16-17 | I(mA) | 1.18 |
| 18 | 17-18 | I(mA) | 1.21 |
| 19 | 18-19 | I(mA) | 1.19 |
| 20 | 19-20 | I(mA) | 1.17 |
| 21 | 20-21 | I(mA) | 1.15 |

(continued)

| No.Transducer | place of Transducer | Transducer (Unit) | Measurement results |
|---|---|---|---|
| 22 | 21-22 | I(mA) | 1.13 |
| 23 | 22-23 | I(mA) | 0.13 |
| 24 | 23-24 | I(mA) | 0.14 |
| 25 | 24-25 | I(mA) | 0.15 |
| 26 | 25-26 | I(mA) | 0.15 |

**Claims**

1. A method of measuring voltage distribution along the metal-oxide surge arrester through wireless communication technology comprising:

   A group of leakage current measuring current transducers (110) with wireless communication module and antenna; One applied testing voltage transducer (120) with wireless communication module and antenna and a RS485 communication interface with the laptop computer (130); The current transducer (110) is formed of insulation plastic material with two thick metal plate covered on each side of the box, the measuring circuit lies in the inside of the box; The voltage transducer (120) is formed of aluminium box (810) with measuring circuits inside the box and with a wireless antenna(820).

2. The method of claim 1, wherein the least number of the measuring current transducer (110) is one; One voltage transducer (120) linked with the laptop computer through a RS 485 converter.

3. The method of claim 1, wherein the measuring current transducers (110) are placed inside the metal-oxide surge arrester (530) between the discs (520) of the metal-oxide surge arrester; The current transducer (110) is formed of insulation plastic material with two thick metal plate covered on each side of the box, the cover of the upper part of the box (350) and the bottom cover of the box (320) are made of printed circuit board with only one side placed with solid polygon plane with a soldering pad (330), the sampling resister (340) and measuring circuit are place inside the box with two wires sold with the upper and lower cover pad (330). The solid polygon copper plane is a bit smaller than the circular printed circuit board, the upper cover (350) and bottom cover (320) are glued with the upper and lower part of the box respectively. The lower part of the current transducer (110) has a hole (210) on its side, a switch (220) is in the hole, when press the switch the current transducer (110) will be powered on and a diode LED (440) will be lighted to indicate whether the current transducer (110) is power on or not.

4. The method of claim 3, wherein the current transducer (110) has a sampling resister (340) and conditioning circuit (920) in the box.

5. The method of claims 1 to 4, wherein the current transducer (110) is formed of microchip computer controller (short for MCU) (410) and a wireless communication module with antenna, sampling resister (430) and conditioning circuit (920), power switch (450), power diode LED indicator (440), battery (470), dip switch (420) ; The wireless communication module with antenna linked with the dip switch (420), battery (470) and power switch (450); The MCU (410) and wireless communication module are supply by the battery (470), to make the current transducer to fulfill the type test of the voltage distribution the power consumption of the circuit should be considered, especially low consumption chip should be adopted; The dip switch (420) is to set the identification address of the current transducer (110), the range of the identification address can be set to 1 to 64.

6. The method of claim 1, wherein the applied voltage to the metal-oxide surge arrester under test is obtained through the voltage transducer (120). The voltage transducer (120) is composed of an aluminium box (810) with a wireless antenna (820) mounted on the side of the aluminium box (810), the voltage transducer (120) can communicate with all current transducers placed inside the surge arrester through the wireless antenna (820) and the wireless antenna inside in the current transducer (110), after that the measuring result of the current transducer (110) and the voltage transducer (120) will be sent to the laptop computer (130) through a RS485 converter. The aluminium box (810) has a RS 485 interface (730) with DB9 connector and a plug to connect the secondary side of the voltage transformer (620) with a two wire shielded cable. The circuit inside the voltage transducer is composed of RS 485 interface (730), RS485 circuit with transient overvoltage protection circuit (740), microchip computer controller (750), battery serves as power supply (760), wireless communication module (770) and voltage measuring circuit and conditioning circuit (780).

7. The method of claims 1 to 6, wherein the wireless measuring system of the voltage distribution along the metal-oxide surge arrester is using the wireless communication technology to measuring the high voltage testing results. The voltage transducer (120) can communicate with all the current transducers (110) placed among the discs of the surge arrester. The voltage distribution results can be calculated through software installed on a laptop computer (130).

FIG.1

220                    210

FIG.2

FIG.3

FIG.4

FIG.5

Laptop
Computer ————— 630(130)

610(120)

RS485

Clap On
Plug

620

Secondary Side of
Voltage Transformer

FIG.6

FIG.7

810

820

FIG.8

FIG. 9

FIG.10

FIG.11

FIG.12

<table>
<tr><td rowspan="2">**INTERNATIONAL SEARCH REPORT**</td><td>International application No.</td></tr>
<tr><td>PCT/CN2011/001919</td></tr>
</table>

**A. CLASSIFICATION OF SUBJECT MATTER**

See the xtra sheet

According to International Patent Classification (IPC) or to both national classification and IPC

**B. FIELDS SEARCHED**

Minimum documentation searched (classification system followed by classification symbols)

  IPC:G01R19, G08C17, H01C7 , H01C8, H01T4

Documentation searched other than minimum documentation to the extent that such documents are included in the fields searched

Electronic data base consulted during the international search (name of data base and, where practicable, search terms used)

DWPI,SIPOABS,CNABS,CNTXT,CNKI： MOA, arrester, light+ w protector, potential w distribut+, voltage w distribut+, wireless, gprs, gsm

**C. DOCUMENTS CONSIDERED TO BE RELEVANT**

| Category* | Citation of document, with indication, where appropriate, of the relevant passages | Relevant to claim No. |
|---|---|---|
| PX | CN 102033184 A   (NORTHEAST ELECTRIC POWER RES. INST. CO., LTD.) 27 Apr. 2011   (27.04.2011)   the whole document | 1-7 |
| PX | CN 202013388 U   (NORTHEAST ELECTRIC POWER RES. INST. CO., LTD.) 19 Oct. 2011 (19.10.2011) the whole document | 1-7 |
| Y | JIN, Wenjie et al., New 500 kV Metal Oxide Surge Arresters Potential Distribution, High Voltage Apparatus, May 2010, vol. 46, no. 5, pages 39-41 | 1-2,7 |
| Y | CN 101833051 A (WUHAN XINDIAN ELECTRICAL TECHNOLOGY CO., LTD.) 15 Sep. 2010 (15.09.2010)   paragraphs 53-86 | 1-2,7 |

  ☒ Further documents are listed in the continuation of Box C.      ☒ See patent family annex.

| | |
|---|---|
| *      Special categories of cited documents: | "T" later document published after the international filing date or priority date and not in conflict with the application but cited to understand the principle or theory underlying the invention |
| "A"   document defining the general state of the art which is not considered to be of particular relevance | |
| "E"   earlier application or patent but published on or after the international filing date | "X"   document of particular relevance; the claimed invention cannot be considered novel or cannot be considered to involve an inventive step when the document is taken alone |
| "L"   document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&"document member of the same patent family |

| Date of the actual completion of the international search | Date of mailing of the international search report |
|---|---|
| 14 Feb. 2012 (14.02.2012) | 23 Feb. 2012 (23.02.2012) |
| Name and mailing address of the ISA State Intellectual Property Office of the P. R. China No. 6, Xitucheng Road, Jimenqiao Haidian District, Beijing 100088, China Facsimile No. (86-10)62019451 | Authorized officer ZHOU, Yapei Telephone No. (86-10)62085865 |

Form PCT/ISA /210 (second sheet) (July 2009)

## INTERNATIONAL SEARCH REPORT

| | International application No. |
|---|---|
| | PCT/CN2011/001919 |

C (Continuation). DOCUMENTS CONSIDERED TO BE RELEVANT

| Category* | Citation of document, with indication, where appropriate, of the relevant passages | Relevant to claim No. |
|---|---|---|
| Y | ZHAO, Miao et al., Potential Distribution Measurement of MOA for 1000 kV AC GIS, High Voltage Apparatus, Jun. 2010, vol. 46, no. 6, pages 10-13 | 1-2,7 |
| Y | CN 201707380 U (SHANGHAI KENEW ELECTRICAL TECHNOLOGY CO.) 12 Jan. 2011 (12.01.2011)   the whole document | 1-2,7 |
| A | CN 101178838 A (XIAN SHENDIAN ELECTRICAL APPLIANCE CO., LTD.) 14 May 2008 (14.05.2008)   the whole document | 1-7 |
| A | CN 101799492 A (HU, Miaolong ) 11 Aug. 2010 (11.08.2010)   the whole document | 1-7 |
| A | JP 10-38947 A (MEIDENSHA CORP.) 13 Feb. 1998 (13.02.1998)   the whole document | 1-7 |

Form PCT/ISA /210 (continuation of second sheet ) (July 2009)

<div align="center">

**INTERNATIONAL SEARCH REPORT**
Information on patent family members

</div>

| | | International application No. |
|---|---|---|
| | | PCT/CN2011/001919 |

| Patent Documents referred in the Report | Publication Date | Patent Family | Publication Date |
|---|---|---|---|
| CN 102033184 A | 27.04.2011 | None | |
| CN 202013388 U | 19.10.2011 | None | |
| CN 101833051 A | 15.09.2010 | None | |
| CN 201707380 U | 12.01.2011 | None | |
| CN 101178838 A | 14.05.2008 | None | |
| CN 101799492 A | 11.08.2010 | None | |
| JP 10-38947 A | 13.02.1998 | None | |

Form PCT/ISA/210 (patent family annex) (July 2009)

**INTERNATIONAL SEARCH REPORT**

International application No.

PCT/CN2011/001919

Continuation of: CLASSIFICATION OF SUBJECT MATTER

G01R31/00 (2006.01)i
G01R19/00 (2006.01)i
G01R1/067 (2006.01)i
G08C17/02 (2006.01)i